# EUROPEAN PATENT APPLICATION

(11) **EP 4 841 288 A1**
(43) Date of publication of application: **18.11.2026**
(21) Application number: 25177083.0
(22) Date of filing: 16.05.2025
(51) Int. Cl.: G01R 33/10, G01R 33/12, H01M 10/48, G01R 33/26

(54) **MEASURING ONE OR MORE MAGNETIC PROPERTIES OF BATTERY COMPONENT AT THE NANO- AND MICRO-SCALE**

(71) Applicant: Danmarks Tekniske Universitet, 2800 Kongens Lyngby (DK); Qnami AG, 4132 Muttenz (CH)
(72) Inventor: Christensen, Dennis, Valbjørn, 2800 Kongens Lyngby (DK); Khoshkalam, Mohamad, 2800 Kongens Lyngby (DK); Pollok, Stefan, 2800 Kongens Lyngby (DK); Rickhaus, Peter, 4132 Muttenz (CH)
(74) Representative: Inspicos P/S

(57) **Abstract**

There is presented a method (100) for measuring one or more magnetic properties, such as a magnetic field and/or a magnetization and/or a magnetic state, of a battery component (332), and for enabling local detection of one or more magnetic inhomogeneities in the battery component, said method comprising: Subjecting (104) the battery component to a measurement of the one or more magnetic properties of the battery component with a measurement technique, wherein the measurement technique for carrying out the measurement is selected between, a scanning probe microscopy (SPM) technique, an electron-beam based technique, and/or an optical technique, where the optical technique is non-invasive, and/or wherein a magnetic sensor, such as any magnetic sensor, is at the surface and/or outside the battery, and wherein the measurement technique for carrying out the measurement is having a submillimetre spatial resolution or a higher spatial resolution.

## Description

### FIELD OF THE INVENTION

The present invention relates to a method for measuring one or more magnetic properties of a battery component, and more particularly a method for measuring one or more magnetic properties of a battery component, wherein the measurement technique for carrying out the measurement is having a submillimetre spatial resolution or a higher spatial resolution, and a corresponding system such as a system adapted to implement said method.

### BACKGROUND OF THE INVENTION

The global pursuit of high-performing batteries faces difficulties in achieving rapid charging, high energy density, low cost, excellent lifetime, and safe operation simultaneously. Analytic tools are generally missing for examining relevant parameters of the batteries, which in turn stands in the way for gaining a deeper understanding of the relevant processes unfolding within the batteries. This knowledge gap constitutes a key hindrance in developing batteries with excellent lifetime, charging time, energy density and safety characteristics.

The article Liu et al., Operando quantum sensing captures the nanoscale electrochemical evolution in batteries, Device (2024), https://doi.org/10.1016/j.device.2024.100521 describes an operando quantum sensing approach in which diamond nitrogen-vacancy (NV) centres are embedded directly into the internal electrodes to detect the electrochemical evolution at the particle level.

Therefore, a method for battery measurements, which is faster, simpler, non-invasive, more accurate, spatially resolved and/or which yields more complete and/or more precise information regarding the relevant processes unfolding within the battery would be advantageous.

### SUMMARY OF THE INVENTION

It may be seen as an object of the present invention to provide a method for measuring one or more magnetic properties of a battery component which is faster, simpler, non-invasive, more accurate, spatially resolved and/or which yields more complete and/or more precise information regarding the relevant processes unfolding within the battery. It may be a further object of the present invention to provide an alternative to the prior art.

Thus, the above-described object and several other objects are intended to be obtained in a first aspect of the invention by providing a method for measuring one or more magnetic properties, such as a magnetic field, such as the magnetic field from a magnetization, and/or a magnetization and/or a magnetic state, of a battery component, and for enabling local detection of one or more magnetic inhomogeneities, such as one or more microscopic inhomogeneities, such as one or more nanoscopic inhomogeneities, in the battery component, said method comprising:
Subjecting the battery component to a measurement of the one or more magnetic properties of the battery component with a measurement technique, wherein the measurement technique for carrying out the measurement is selected between,
- A scanning probe microscopy (SPM) technique,
- An electron-beam based technique, and/or
- An optical technique, where
   i. the optical technique is non-invasive, and/or
   ii. wherein a magnetic sensor, such as any magnetic sensor, is at the surface and/or outside the battery,
and wherein the measurement technique for carrying out the measurement, such as the measurement being the measuring of the one or more magnetic properties, is having a submillimetre spatial resolution or a higher spatial resolution, such as double-digit micrometre spatial resolution or a higher spatial resolution, such as single-digit micrometre spatial resolution or a higher spatial resolution, such as submicrometre spatial resolution or a higher spatial resolution, such as double-digit nanometre spatial resolution or a higher spatial resolution, such as single-digit nanometre spatial resolution or a higher spatial resolution.

The invention may be advantageous for providing a method for measuring one or more magnetic properties of a battery component wherein the measurement technique for carrying out the measurement is having a submillimetre spatial resolution or a higher spatial resolution, which may yield more accurate and/or more precise information regarding the relevant processes unfolding within the battery. Such submillimetre spatial resolution or a higher spatial resolution measurement of a one or more magnetic properties of a battery component may further reveal critical information about said one or more magnetic properties that are averaged out in measurements with lower spatial accuracy, enabling predictive insights not otherwise obtainable. This information may in turn be useful for improving batteries.

The invention may be advantageous for enabling more complete information, e.g., maps or images of battery components (e.g., as opposed to yielding/sampling information only in relation to separated, discrete areas or volumes within a battery component, which happens to be adjacent to an embedded magnetic sensor, such as an embedded NV centre). Mapping or imaging said magnetic properties of a battery component may reveal information about the spatial distribution of a variety of sources within said battery component of magnetic field, and potentially information about their time evolution upon operational cycles.

The invention may be advantageous for enabling and/or the invention may in embodiments include one or more of:
- Determining a local electronic density of state from Curie-Weiss paramagnetism,
- Determining point defects and optionally their spatial distribution, such as interdiffusion between lithium and transition metal ions, such as Li-Ni interdiffusion,
- Determining redox-active transition metal ions *in situ* or *in-operando,* such as without one or more synchrotron(s),
- Nanoscale, non-invasive, and *in situ* or *operando* tracking of battery degradation, such as without synchrotron(s) and/or TEM lamellas, and/or
- Determining battery features being magnetically ordered, residing on a non-magnetic background, and present in very small volumes.

'Magnetic field' is understood as is common in the art, such as magnetic flux density (commonly referred to as the B-field) or auxiliary magnetic field (commonly referred to as H-field), such as unless otherwise stated the magnetic flux density (B-field), such as the magnetic flux density (B-field).

The invention may be advantageous for being fast and/or simple in that it enables dispensing with a need for embedding one or more magnetic sensors, such as one or more embedded NV centres, in the battery component.

Additionally, by dispensing with a need for such embedding, the invention may be advantageous for enabling omitting said embedding, which may in turn be advantageous for dispensing with advanced fabrication techniques, reducing cost, reducing complexity and/or enabling ruling out any effect(s) said embedding and/or the presence of the embedded magnetic sensor(s) might have on the measurements.

As an example for comparison, the implementation of the method described in the article of Liu *et al.,* (Liu et al., Operando quantum sensing captures the nanoscale electrochemical evolution in batteries, Device (2024), https://doi.org/10.1016/j.device.2024.100521) necessitates the embedding of diamond nanocrystals directly within the battery electrode material. Such integration is invasive in the sense that it induces physical and/or chemical modification of the electrode material itself, potentially resulting in the disruption of the electrode's microstructural uniformity and mechanical properties, as well as adversely affecting ion transport pathways. Furthermore, achieving uniform dispersion of diamond nanocrystals requires advanced fabrication techniques, resulting in substantial increasing of cost and processing complexity.

The invention may furthermore be advantageous for enabling real-time monitoring, such as during operation of the battery component. The ability to monitor changes in real-time may allow for dynamic assessment of battery health and/or battery degradation pathways during operation, leading to proactive maintenance and optimization strategies rather than reactive ones.

The method, which may be embodied as a magnetic imaging technique, may enable spatially resolving inhomogeneities and degradation mechanisms with submillimetre, such as submicrometre, such as sub-nanometre, spatial resolution, which inhomogeneities may be comprising of magnetically ordered particles and phases in battery materials, such as battery cathode materials, different state of charge in cathode and anode materials, induced magnetization in cathode and anode materials, dendrite formation during battery operation, and interdiffusion at cathode/electrolyte as well as anode/electrolyte interfaces.

The limiting factor for improving the energy density, power density and cycling stability further in high-performing battery architectures is spatial inhomogeneities and related degradation mechanisms of the constituent battery components, which directly translates to, e.g., inferior lifetime, inferior battery capacity (e.g., translating into inferior driving ranges in case of electric vehicles) and inferior charging times.

Analytic tools are generally missing for detecting the spatial inhomogeneities as the buried nature of these degradation phenomena in battery components blocks direct access to understanding the local processes unfolding at the nanoscale. This knowledge gap constitutes a key hindrance in developing batteries with excellent lifetime, charging time, energy density and safety characteristics.

It may be seen as an insight of the present inventors that materials can exhibit completely different signals at the micro- or nano-scale compared to macro-scale. Although battery materials are generally associated with weak magnetism (molar susceptibility χₘₒₗ<10⁻⁶ m³/mol at 300 K), the present inventors have discovered that relatively strong magnetic fields, such as magnetic fields associated with micro- or nanoscale centres with magnetic orders differing from surrounding material, such as nanoscale ferromagnetic centres, exist in batteries. These unexpected micro- or nanoscale centres with magnetic orders differing from surrounding material and associated magnetic stray fields cannot be detected at the macro-scale as they are relatively small, such as relatively small relative to a macro-scale, and may be only present in low total volumes, such as wherein "total volumes" in this context refers to the total, aggregated volume of the one or more micro- or nanoscale centres with magnetic orders differing from surrounding material. Nonetheless, using a tool with submillimetre, such as micro-or nanoscale spatial resolution, one can detect these inhomogeneities, such as detect these inhomogeneities at the microscale or at the nanoscale. 'Centre', such as 'micro-or nanoscale centre(s)', may in this context be understood as a volume, such as a delimited volume, such as a delimited micro- or nanoscale volume.

It may be seen as another insight of the present inventors that the weak signals associated with battery constituents being either diamagnetic or paramagnetic are detectable at room temperature.

A 'magnetic property' is understood as is common in the art, such as a magnetic field, such as wherein magnetic field may in the context of magnetic property by understood as the field commonly referred to as B-field (also referred to as magnetic flux density) or the field commonly referred to as H-field (also referred to as auxiliary magnetic field), and/or an inherent property that influence or determine magnetic behaviour, such as magnetization, magnetic susceptibility (χ), paramagnetic susceptibility, permeability (µ), coercivity, remanence, Curie temperature, Néel temperature, blocking temperature, magnetic spin glass temperature, and/or a magnetic state. For any of the properties, it may be understood to be given for certain conditions, e.g., zero externally applied magnetic field, non-zero externally applied magnetic field, a certain temperature, e.g., below a Curie temperature, etc.

A "magnetic state", as used herein, is understood as is common in the art (and may alternatively be referred to, e.g., as type of magnetism), such as referring to an ordering system comprising well known magnetic ordering types, such as ferromagnetic, antiferromagnetic, ferrimagnetic, paramagnetic, diamagnetic ordering. The magnetic state of a material, such as a region of a material, may be given by the structure of the material, in particular its electron configuration, and may be dependent on, e.g., temperature

A 'battery component' is understood as is common in the art, such as any component of a battery, such as an anode, a cathode, or an electrolyte. It may be understood that the battery component is a real battery component, such as real battery component of a real battery, such as wherein the battery component is part of a battery during the measurement, such as wherein the battery component is a battery. This may be opposed to, e.g., measurements on (merely) a cathode degradation product (i.e., not a real cathode).

The battery component may be a cathode, such as a cathode comprising, such as consisting of, the cathode material LiₓCoO₂, LiFePO₄, LiNi_{1-x-y}CoₓAl_{y}O₂, LiMn₂O₄, LiNi₁₋ₓCoₓO₂, LiNiₓMn_{y}Co_{1-x-y}O₂, NaNi_{1-x-y}MnₓFe_{y}O₂, Na₃V₂(PO₄)₃, NaFePO₄, Na₂FePO₄F, Na₂FeFe(CN)₆, NaFeMn(CN)₆, Na₃V₂(PO₄)₃, Na₂Fe₂(SO₄)₃, Na₂Mn(SO₄)₂, KxMnO₂, KFeFe(CN)₆, KVPO₄F, TiS₂, V₂O₅, AlFe(CN)₆ Sulfur, NiOOH, MgFeSiO₄, MgMn₂O₄, MnO₂, and/or ZnₓV₂O₅·nH₂O.

The battery component may be an anode, such as an anode comprising, such as consisting of, the anode material,
- such as a the anode material being a metal,
   - such as Lithium (Li) or Sodium (Na), Potassium (K), Aluminium (Al), Nickel (Ni), Cadmium (Cd), or Zinc (Zn), and/or
- such as the anode material being a carbon based material,
   - such as graphite, graphene, or Carbon black, and/or
- such as the anode material being a metal hydride, such as LaNi₅H₆, and/or
- such as the anode material being silicon based, such as Si and/or SiOₓ, and/or
- such as the anode material being Li₄Ti₅O₁₂ (LTO).

The battery component may be an electrolyte, such as an electrolyte comprising, such as consisting of, the electrolyte material Li₇La₃Zr₂O₁₂ (LLZO). The electrolyte may be
- a solid electrolyte, such as comprising, such as consisting of,
   - Li₇La₃Zr₂O₁₂ (LLZO), Li₃xLa₂/₃₋xTiO₃ (LLTO), Li₁+xAlₓTi₂₋ₓ(PO₄)₃ (LATP), Li₁₀GeP₂S₁₂ (LGPS), Li₇P₃S₁₁, Li₆PS₅Cl, Li₆PS₅Br, Poly(ethylene oxide)+salt, poly(methyl methacrylate) (PMMA)+salt, PAN+salt, and/or PVDF-based+salt, and optionally
   - One or more separators,
      i. such as the one or more separators comprising, such as consisting of, glass fibers, Polyolefin (e.g., Polyethylene NOTE (PE), Polypropylene (PP)), Polyvinylidene fluoride (PVDF), Polyacrylonitrile (PAN), Polyethylene oxide (PEO), and/or PVDF,
   or
- a liquid electrolyte, such as comprising one or more solvents,
   - such as the one or more solvents comprising, such as consisting of, one or more of Ethylene carbonate (EC), Dimethyl carbonate (DMC), Diethyl carbonate (DEC), Propylene carbonate (PC), Ethyl methyl carbonate (EMC), Water, Tetraethylene glycol dimethyl ether (TEGDME), and Dimethyl ether (DME), Tetrahydrofuran (THF), and/or Dimethoxyethane (DME), and
   - one or more salts.

'Salt' may in the context of the solid electrolyte be any one or more of the following, including combinations of the following: LiPF₆, LiBF₄, LiTFSI, LiFSI, LiClO₄, NaPF₆, NaClO₄, NaTFSI, NaFSI, NaBF₄, KPF₆, KTFSI, KFSI, KClO₄, ZnSO₄, Zn(CF₃SO₃)₂, ZnCl₂, Zn(OTf)₂, Mg(TFSI)₂, Mg(BH₄)₂, Mg(ClO₄)₂, MgAlCl₄, AlCl₃, and/or Al(TFSI)₃.

'Salt' may in the context of the liquid electrolyte be any one or more of the following, including combinations of the following: LiPF₆, LiBF₄, LiTFSI, LiFSI, LiClO₄, NaPF₆, NaClO₄, NaTFSI, NaFSI, NaBF₄, KPF₆, KTFSI, KFSI, KClO₄, ZnSO₄, Zn(CF₃SO₃)₂, ZnCl₂, Zn(OTf)₂, Mg(TFSI)₂, Mg(BH₄)₂, Mg(ClO₄)₂, MgAlCl₄, AlCl₃, Al(TFSI)₃, KOH, NaOH, MgCl2, AlCl3, and/or LiOH.

In the salts,
- the letters "TFSI", such as in each one of LiTFSI, NaTFSI, KTFSI, Mg(TFSI)₂, Al(TFSI)₃, is bis(trifluoromethanesulfonyl)imid, such as the bis(trifluoromethanesulfonyl)imid anion ([(CF₃SO₂)₂N]⁻),
- the letters "FSI" when not preceded by a capital "T", i.e., when not being in the form "TFSI", such as in each one of LiFSI, NaFSI, and KFSI, is bis(fluorosulfonyl)imide, such as the bis(fluorosulfonyl)imide anion ([(FSO₂)₂N]⁻), and
- Zn(OTf)₂ is zinc bis(trifluoromethanesulfonate).

The electrolyte material can be mixed with, anode (in the anode component) and/or cathode material (in the cathode component) for enhanced performance.

The electrodes (e.g., cathode active material, such as LiFePo4) may be mixed with other materials, such as binders (e.g., to keep the structural integrity), and electronically conducting elements (e.g., carbon). Cathode active particles may also be coated or doped, e.g., for enhanced performance and/or minimized degradation. In addition, the electrode particles may also be surrounded by electrolyte (solid or liquid), e.g., for enhanced ionic conductivity.

A 'battery' is understood as is common in the art, such as a device that stores chemical energy, such as stored within its active materials, and which chemical energy can be converted directly into electric energy. The battery may be any one of a lithium-ion, sodium-ion, potassium-ion, primary and secondary zinc, magnesium-ion, high-temperature sodium-sulphur, Zero Emission Battery Research Activity (ZEBRA), molten-salt, Nickel-metal hydride (Ni-MH), Nickel-Cadmium, Aluminium-sulphur, solid-state, and/or hybrid solid-state battery. The active ion in the battery may be any mobile ion, such as an ion or ions of lithium, sodium, potassium, aluminium, magnesium, calcium, iron, protons (H⁺) and/or zinc.

'Detection' is understood as is common in the art, such as detection (i.e., verification of the presence) of an event or condition, e.g., the presence of an area or volume exhibiting a certain property, e.g., a magnetic property, such as a magnetic property demonstrating a value above or below a certain threshold. The magnetic property, such as the one or more magnetic properties which is detected, may be one or more or all: Magnetic state, super-paramagnetism, spin glass state, paramagnetism, and/or magnetic order.

'Local detection' is understood as is common in the art, such as detection and localization, such as determination of spatial location of the detected entity, such as an area or volume exhibiting a certain property, e.g., a magnetic property, such as magnetization or magnetic state, such as a magnetic property exceeding a certain threshold, and optionally size, shape and/or orientation of the detected entity.

'Enabling local detection' is understood as is common in the art, such as providing information, such as raw data, such as an image or a map, which enables the local detection.

'Magnetic inhomogeneities' are understood as is common in the art, such as areas on a surface or within the sub-surface volume with one or more magnetic properties being different with respect to the surrounding areas or volumes.

'Surface' is understood as is common in the art, such as an interface with respect to the surroundings.

By 'on a surface' may be understood that an element (such as one or more magnetic inhomogenetities) is in physical contact with the surface (e.g., touching and/or at zero distance) or positioned in sufficiently close proximity to the surface such that a functional interaction occurs. This includes configurations where the element is separated from the surface by a nanometer-scale gap (such as a non-zero gap being less than 1 µm, such as less than 100 nm, such as less than 10 nm).

'Microscopic inhomogeneities' are understood as is common in the art, such as areas on a surface or within the sub-surface volume with one or more properties being different with respect to the surrounding areas or volumes, wherein these inhomogeneities are microscopic, such as being less than a millimetre in size in one or more or all dimensions.

'Scanning probe microscopy (SPM)' is understood as is common in the art, such as microscopy realized via scanning a probe across a surface, e.g., in a raster pattern.

An 'electron-beam based technique' is understood as is common in the art, such as techniques relying on an electron beam, such as any of Lorentz electron microscopy, Lorentz transmission electron microscopy (Lorentz TEM), Lorentz scanning transmission electron microscopy (Lorentz STEM), Electron holography, Magnetic-field-free Atomic-Resolution STEM (MARS STEM), Electron vortex beam microscopy and Scanning Electron Microscopy with Polarization Analysis (SEMPA).

An 'optical technique' is understood as is common in the art, such as techniques based on electromagnetic radiation, such as light, of any wavelength, such as visible light, such as having wavelengths within a range of [400 nm; 700 nm], and/or X-rays, such as having wavelengths within a range of [10⁻¹² m; 10⁻⁸ m]. Examples of optical techniques that are sensitive to magnetic properties include Kerr microscopy and X-ray magnetic Circular Dichroism (CD).

According to embodiments of the invention, the optical technique is given by NV magnetometry as a wide-field imaging technique and/or as a confocal imaging technique.

'Non-invasive' is understood as is common in the art, such as not entering into another entity. It may be understood that 'non-invasive' may be seen as a sub-set of non-destructive (e.g. in the sense that a method may be invasive without being destructive, i.e., invasive and non-destructive).

By a 'non-invasive' measurement technique may more particularly be understood a measurement technique capable of probing an inherent magnetic property, such as magnetization and/or magnetic state, of a battery component, such as without relying on embedded sensors, such as embedded diamond particles as described, e.g., in the above-mentioned reference Liu et al., Operando quantum sensing captures the nanoscale electrochemical evolution in batteries, Device (2024), https://doi.org/10.1016/j.device.2024.100521.

A 'magnetic sensor' is understood as is common in the art, such as an entity, such as any device, component or system, configured to detect, measure, or respond to the presence, magnitude, direction and/or gradient of a magnetic property or a magnetic field, and further configured to produce a measurable output signal, such as an optical, electrical, or magnetic (such as a magnetic flux) signal, that correlates with one or more characteristics of the detected and/or measured magnetic property or magnetic field.

The magnetic sensor may be the entity in a measurement technique, which is responsible for converting the presence of a magnetic property or a magnetic field into a signal (such as an optical signal), which is the signal detected in the measurement technique and used to infer the presence and/or magnitude of the magnetic property or the magnetic field.

By 'at the surface' may be understood that there is contact with the surface, such as wherein an element at the surface is touching the surface and/or is at zero distance with respect to the surface.

'Outside the battery' is understood as is common in the art, such as not being encompassed by the surface of the battery, such as not being encompassed by the surface of the battery and being at a non-finite distance, such as non-zero distance, with respect to the surface of the battery.

'Resolution' is understood as is common in the art, such as the capability of resolving details, such as nearby objects in real space, at a separation corresponding to the resolution.

It is understood that the measurement is carried out at the mentioned resolution, such as the measurement being carried out with 'a submillimetre spatial resolution or a higher spatial resolution, such as double-digit micrometre spatial resolution or a higher spatial resolution, such as single-digit micrometre spatial resolution or a higher spatial resolution, such as submicrometre spatial resolution or a higher spatial resolution, such as double-digit nanometre spatial resolution or a higher spatial resolution, such as single-digit nanometre spatial resolution or a higher spatial resolution' (i.e., encompassing the measurement being carried out at the mentioned resolution which might be lower than the resolution of the measurement technique), such as with a resolution corresponding to the resolution of the measurement technique.

'Submillimetre spatial resolution' is understood as is common in the art, such as the capability of resolving details, such as nearby objects in real-space, at submillimetre separation.

'A higher spatial resolution' is understood as is common in the art, such as a better resolution and/or a capability of resolving details which are at less separation, such as separated by a smaller distance (such as, e.g., 'nanometre spatial resolution' being or warranting a higher resolution than 'micrometre spatial resolution').

The invention may be embodied via one or more of the techniques, such as widefield and confocal NV magnetometry, described in the reference D V Christensen, et al., 2024 roadmap on magnetic microscopy techniques and their applications in materials science, J. Phys. Mater. 7 (2024) 032501, which reference is hereby included by reference in entirety.

According to an embodiment there is presented a method, wherein the method is further comprising:
- Locally detecting one or more magnetic inhomogeneities based on the measurement of the one or more magnetic properties of the battery component.

The step of 'locally detecting one or more magnetic inhomogeneities' may be done by eye (e.g., in case data of the measurement of the one or more magnetic properties of the battery component is provided in, e.g., an image or a map). Alternatively, said step can be partially or fully automated, e.g., via a computer program product and/or using one or more algorithms to estimate or determine the magnetic inhomogeneities from data, such as raw data (e.g., a signal representative of a magnetic stray field) optionally supplemented by manual input. For example, it may be possible to solve the inverse problem of extracting magnetization from measurement data of a magnetic stray field, e.g., by using algorithms to invert measurement data of a magnetic stray field into knowledge of the magnetic inhomogeneities. In any case, said step may result in data spatially locating the one or more inhomogeneities.

A possible advantage of this step may be that it may (e.g., via data spatially locating the one or more inhomogeneities) enable gaining information about the battery component, such as the underlying origins of the measured one or more magnetic properties, which may optionally in turn be used for improving a new generation of battery components.

According to an embodiment there is presented a method, wherein the measurement comprises:
- Applying an external magnetic field,
- Determining the one or more magnetic properties, such as at least an intensity and/or direction of a magnetic stray field, during the applying of the external magnetic field.

'Applying an external magnetic field' is understood as is common in the art, such as using a magnet, such as an external magnet, such as a vector magnet and/or a tunable magnet, such as an external, tunable, vector magnet, to apply an external magnetic field. The external magnetic field may be understood to be the magnetic field, which would be present in the absence of the battery component or the battery of the battery component, and that an actually present magnetic field may be different due to, e.g., a magnetic field (component) resulting from a magnetization of the battery component.

An advantage of applying a magnetic field (or multiple different magnetic fields) may be that it enables probing certain magnetic properties, such as magnetic order, paramagnetism and/or magnetization of the battery component. According to embodiments, by measuring a response (such as change in magnetic stray field) to an applied, external magnetic field, information about the magnetic order and/or susceptibility is inferred.

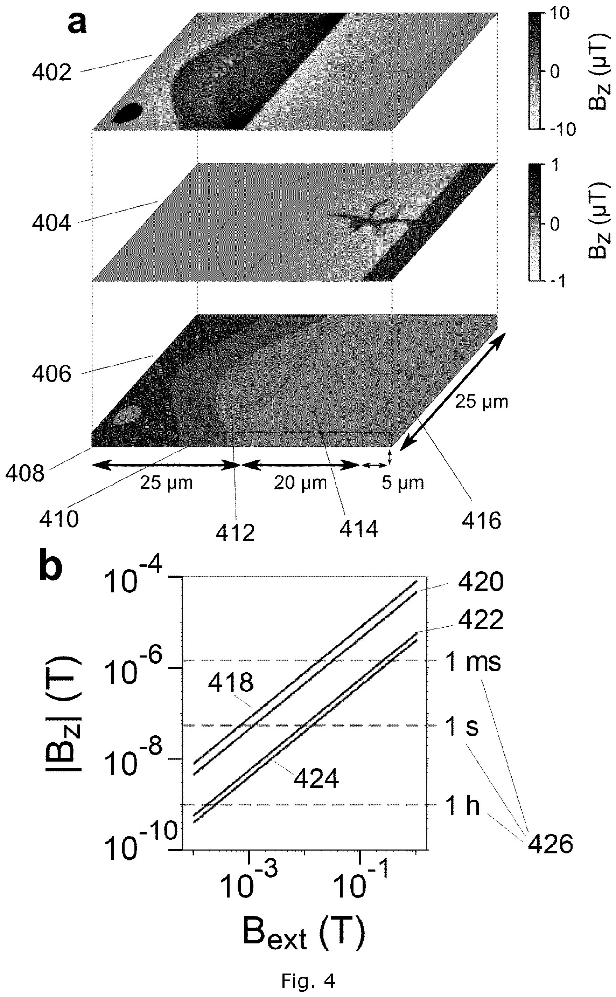

For example, applying an external magnetic field of for example 100 mT produces a magnetic stray field from the paramagnetic lithium metal (cf., e.g., Figure 4a), which can be used to directly image the local state-of-charge, dendrites, and/or lithium metal inclusions (as shown in Figure 4a).

'Determining the one or more magnetic properties, such as at least an intensity and/or direction of a magnetic stray field, during the applying of the external magnetic field' may be done either via one or more measurements done solely during application of a constant external magnetic field, such as a constant non-zero external magnetic field, or it may be done via multiple measurements, where for each of a plurality of different applied, external magnetic fields, one or more measurements is carried out. The different applied, external magnetic fields may be different with respect to each other due to one or more of a scalar field strength, a change in sign of field strength and/or a change in vectorial direction, optionally in any of 3 dimensions).

Examples of determining the one or more magnetic properties during the applying of the external magnetic field via multiple measurements, where for each of a plurality of different applied, external magnetic fields, one or more measurements is carried out, include:
- applying a series of constant magnetic fields, wherein each constant magnetic field in the series differs with respect to other constant magnetic fields in the series,
- applying alternating currents and measuring the alternating response with, e.g., NV magnetometry.

The latter approach (with alternating currents) can be particularly useful for measuring paramagnetism and/or for enabling the use of pulsed protocols, such as XY-8, that eliminate background constant magnetic fields.

According to an embodiment there is presented a method, wherein the measurement comprises:
- Determining the one or more magnetic properties, such as at least an intensity and/or direction of a magnetic stray field at a first temperature, and
wherein the measurement further comprises, optionally repeatedly:
- Changing the temperature of the battery component to a new temperature, such as a temperature at which the previous one or more determinations of the one or more magnetic properties has not or have not taken place, and
- Determining the one or more magnetic properties, such as at least an intensity and/or direction of a magnetic stray field at the new temperature.

An advantage of this may be that it enables temperature-dependent measurements to thermally activate or reduce ionic transport as well as determining magnetic transition temperatures. An advantage of the latter is that it can be used to determine the origin of the magnetization.

According to an embodiment there is presented a method, wherein the one or more magnetic properties include at least a paramagnetic susceptibility.

An advantage of determining the paramagnetic susceptibility may be that it enables gaining information of the chemical heterogeneity, redox reactivity, state-of-charge, and/or state-of-health. Paramagnetic measurements may for example be used to determine information about dendrites, such as formation of dendrites, redox heterogeneity and/or local state-of-charge in the electrodes (cathodes and anodes), and/or redox-active elements in the electrodes.

According to an embodiment there is presented a method, wherein the method comprises probing buried structures, such as structures below a layer, such as a surface layer, being different to the buried structures.

An advantage may be that, e.g., via scanning NV magnetometry, information is gained about structures buried below a surface layer. For example, it may be possible to visualize anode redox processes even when the air-sensitive pure metal anodes are covered by protective layers.

'Probing' is understood as is common in the art, such as measuring upon and/or wherein a measurement is affected by the probed structures, such as wherein the measurement yields information about the probed structures.

According to an embodiment there is presented a method, wherein the measurement technique is selected between
i. The Scanning Probe Microscopy technique, and/or
ii. The electron-beam based technique.

The Scanning Prope Microscopy technique may be scanning nitrogen vacancy (NV) magnetometry. A possible advantage of relying on scanning nitrogen vacancy (NV) magnetometry may be that it enables one or more or of high resolution, sensitivity to buried structures, and/or dispensing with elaborate requirements (such as a need for synchrotron radiation),

According to an embodiment there is presented a method, wherein the measurement technique is a Scanning Probe Microscopy technique, which is a magnetic imaging technique utilizing any of:
- a solid-state lattice sensor, such as a solid-state lattice sensor of diamond material or non-diamond material, such as hexagonal boron nitride or silicon carbide, wherein the solid-state lattice sensor is optionally configured as a scanning probe, the apex of said probe comprising one or more single spin defects, such as a nitrogen vacancy (NV), such as wherein sensing involves irradiating the spin defect(s) (such as an NV(s)) by applying optical radiation (L) and a microwave field continuously or in one or more pulses to the spin defect(s) (such as the NV(s)) such as to detect a Zeeman shift upon exposure of the irradiated spin defect(s) to the magnetic field of the sample, and detecting a photoluminescence (PL) output signal from the solid-state lattice sensor comprising the spin defect(s) (such as the NV(s)),
- a Superconducting Quantum Interference Device (SQUID) sensor, such as a scanning SQUID sensor, such as a SQUID sensor consisting of a superconducting loop interrupted by two or more Josephson junctions (JJs) to form a DC voltage develops across the SQUID,
- a Hall sensor, such as configured as a scanning Hall probe, such as a Hall sensor with an operating current, which forms a transverse voltage corresponding to the local magnetic field,
- A magneto-resistive sensor, such as configured as a scanning magneto-resistive probe, such as a magneto-resistive sensor with an operating current in which the resistance of said sensor corresponds to the local magnetic field,
- a Magnetic Force Microscope (MFM), such as wherein magnetic interactions between the sample and a magnetic tip or nanowire on an oscillating cantilever is arranged for, and optionally used to, generate a map of the magnetic field from a sample,
- a Scanning Tunnelling Microscope (STM), wherein the detection of a spin-component of tunnelling current is used to infer the local magnetization of the sample, or
- an Atomic Force Microscope (AFM), such as a non-contact Atomic Force Microscope (nc-AFM) or Magnetic Exchange Force Microscopy (MExFM), wherein the local forces related to magnetic exchange between the sample and an atomic force microscopy tip is used to generate a map of the magnetic state of the sample.

A possible advantage of this SPM magnetic imaging technique may be that it yields a high resolution and that it enables measuring at least some relevant magnetic properties otherwise being non-detectable or invisible at the macroscale.

A technique, such as a technique for assessing one or more magnetic properties, utilizing 'a solid-state lattice sensor, the apex of said probe comprising one or more single spin defects in the form of a nitrogen vacancy (NV)', may be referred to as 'NV magnetometry'.

A magnetic imaging technique utilizing 'a solid-state lattice sensor, wherein the solid-state lattice sensor is optionally configured as a scanning probe, the apex of said probe comprising one or more single spin defects in the form of a nitrogen vacancy (NV)', may be referred to as 'scanning NV magnetometry'.

In an embodiment, such as the embodiment utilizing a solid-state lattice sensor, the measurement technique may be as described in WO 2014/051886 A1 and/or WO 2023/285966 A1, each of which is hereby included by reference in entirety.

The techniques based on Atomic Force Microscope (AFM) may be understood to detect short-range magnetic exchange forces between a magnetic probe and sample. MFM may be understood to detect long-range magnetic dipole interactions. In this context, 'short-range' and 'long-range' may at least be understood to be relative to each other, such as 'short-range' being understood to relate to shorter ranges than 'long-range'.

According to an embodiment there is presented a method, wherein the measurement technique comprises:
- a) movably positioning a sensing surface of a solid-state lattice sensor, such as a solid-state lattice sensor of diamond material or non-diamond material, such as hexagonal boron nitride or silicon carbide, comprising one or more spin defects in the vicinity of the apex, such as at or in the apex, of the solid-state lattice sensor, at a first scanning position in proximity of the battery component,
- b) irradiating the one or more spin defects by applying optical radiation (L) and a microwave field continuously or in one or more pulses to the one or more spin defects such as to detect a Zeeman shift upon exposure of the irradiated one or more spin defects to the magnetic field of the battery component,
- c) detecting a photoluminescence (PL) output signal from the solid-state lattice sensor comprising the one or more spin defects,
- d) scanning the surface of the battery component in performing steps a) to c) at a series of scanning positions over at least a portion of the length of the battery component such as to obtain quantitative information on the magnetic field spatial distribution.

As used herein, "scanning the surface" is intended to encompass both modalities of discrete and continuous measurements. In some embodiments, scanning the surface may comprise acquiring data at individual spatial locations in a point-by-point manner, wherein the scanning probe is positioned at specific coordinates to perform localized measurements before proceeding to the next point. In other embodiments, scanning may be performed continuously, wherein the probe moves in a controlled trajectory, such as a raster or linear scan, while acquiring data in real time.

The wording 'in or at the apex' is to be understood as is common in the art, such as 'in the apex' to be understood as the spin defect being comprised within, such as entirely within, the apex, and/or such as 'at the apex' to be understood as in physical contact with the apex, such as touching the apex, i.e., encompassing being outside the apex and touching the apex.

The measurement technique according to this embodiment may be as described in WO2014/051886 A1 and/or WO 2023/285966 A1, each of which is hereby included by reference in entirety.

According to an embodiment there is presented a method, , wherein said quantitative information on the magnetic field spatial distribution is processed and displayed on a computer-based product, such as a screen or monitor, such as so that the spatially resolved magnetic field data is visualized in real time and/or as a reconstructed magnetic field map.

According to an embodiment there is presented a method, wherein the measurement technique, such as the scanning probe microscopy technique, is having double-digit micrometre spatial resolution or a higher spatial resolution, such as single-digit micrometre spatial resolution or a higher spatial resolution, such as submicrometre spatial resolution or a higher spatial resolution, such as double-digit nanometre spatial resolution or a higher spatial resolution, such as single-digit nanometre spatial resolution or a higher spatial resolution.

According to an embodiment there is presented a method, wherein the measurement technique, such as the scanning probe microscopy technique, is having a submicrometre spatial resolution or a higher spatial resolution, such as double-digit nanometre spatial resolution or a higher spatial resolution, such as single-digit nanometre spatial resolution or a higher spatial resolution.

According to an embodiment there is presented a method, wherein the method comprises capturing evolution, such as electrochemical evolution, by repeating one or more times:
- Subjecting the battery component to a measurement of the one or more magnetic properties of the battery component with the measurement technique, and
- Locally detecting one or more magnetic inhomogeneities based on the measurement of the one or more magnetic properties of the battery component,
such as wherein electrochemical reactions are induced, such as by having the battery component being electrically operated between and/or during the measurements, such as by having the battery component being electrically operated, such as in a manner being or mimicking a working situation, such as charging and/or discharging, such as performing a charge-discharge cycle, between and/or during the measurements.

A possible advantage of this may be that it enables obtaining information during more realistic circumstances, such as the temporal evolution of the measured magnetic properties upon operational cycles, which may in turn be beneficial for enabling the development of an improved subsequent generation of battery components.

According to an embodiment there is presented a method, wherein the measurement takes place while the battery component is placed in a hollow element shielding the battery component from atmospheric air and/or moisture, such as the hollow element being a glovebox or a sealed enclosure.

A possible advantage of this may be that the battery may thus be shielded from atmospheric air and/or moisture, which could otherwise have led to unnatural degradation, e.g., compared to realistic conditions during use. Another possible advantage may be that it enables carrying out the measurement in the hollow element, which may in turn enable direct access to the battery component.

By 'shielding' us understood that air and/or moisture cannot move freely, e.g., by diffusion, convection, wind or drag, such as move freely past the shielding.

According to an embodiment there is presented a method, wherein the measurement is an *in situ,* such as an *operando,* measurement, such as repeated or continuous measurement while the battery component is being electrically operated, such as electrically operated in a manner being or mimicking a working situation, such as while charging and/or discharging, such as during a charge-discharge cycle.

A possible advantage of this may be that it enables obtaining information during more realistic circumstances, which may in turn be beneficial for enabling the development of an improved subsequent generation of battery components.

'*In situ'* is understood as is common in the art, such as relating to the natural or original position or place, such as wherein *in situ* measurement refers to a measurement being carried out while the object of examination is in the natural or original position or place, such as a battery component being in a battery in an operating state.

'*Operando'* is understood as is common in the art, such as relating to (normal) operating conditions, such as wherein *operando* measurement refers to a measurement involving repeated, such as continuous, data collection under (normal) operating conditions.

According to an embodiment there is presented a method (sensing protocol), comprising, such as comprising sequentially:
- Optionally charging a battery with the battery component up to a state-of-charge, such as a desired state-of-charge,
- subjecting the battery component to the measurement of the one or more magnetic properties of the battery component, such as in-situ,
- charging, such as charging again, the battery, such as charging more, such as a little more,
- subjecting, such as subjecting again, the battery component to the measurement of the one or more magnetic properties of the battery component, such as in-situ.

An advantage might be that in this way, it may be possible to measure the full battery charge/discharge process using a set of snapshots. This might be beneficial, e.g., in case the measurements take relatively long time.

According to an embodiment there is presented a method, wherein the method comprises providing a battery component with one or more magnetic inhomogeneities, such as wherein the one or more magnetic inhomogeneities are resulting from any one or more of:
- rock salt formation in cathode materials,
- oxygen loss in cathode materials,
- phase transition in cathode and anode materials,
- magnetically ordered particles and phases in battery cathode materials,
- transition metal dissolution,
- Interdiffusion between transition metal ions and active ions such as lithium ions,
- different states of charge in cathode and anode materials,
- induced magnetization in cathode and/or anode materials,
- dendrite formation during battery operation,
- interdiffusion at cathode/electrolyte as well as anode/electrolyte interface,
- cathode and anode materials decomposition,
- solid electrolyte interphase (SEI) formation, and/or
- cathode electrolyte interphase (CEI) formation.

According to an embodiment there is presented a method, wherein each of the magnetic inhomogeneities has a largest dimension being 10 µm or less, such as 1 µm or less.

According to an embodiment there is presented a method, wherein each of the magnetic inhomogeneities has a largest dimension being 100 nm or less, such as 10 nm or less.

According to a second aspect of the invention there is presented a system for measuring one or more magnetic properties, such as a magnetic field, such as the magnetic field from a magnetization, and/or a magnetization and/or a magnetic state, of a battery component, said system comprising:
- A measurement instrument for measuring one or more magnetic properties of a battery component with a measurement technique according to the first aspect, such as for carrying out the method according to the first aspect,
wherein the system is further comprising one or more or all of:
- A hollow element for shielding the battery component from atmospheric air and/or moisture during the measuring of the one or more magnetic properties of the battery component, such as the hollow element being a glovebox or a sealed enclosure,
- A temperature controller, such as comprising
   i. a temperature actuator, such as a heater and/or Peltier element and/or cooling fan and/or circulating bath,
   ii. a regulator and
   iii. optionally a temperature sensor,
- A magnet, such as a vector magnet and/or a tunable magnet, and/or
- An electrical unit for applying electrical signals to the battery component during the measuring of the one or more magnetic properties of the battery component and/or for performing electrical analysis of the battery component during the measuring of the one or more magnetic properties of the battery component, such as wherein the electrical unit is
   i. An *in situ* module, such as an *operando* module,
   ii. A Potentiostat with the capability of doing
      1. Galvanostatic cycling with potential limitations (GCPL),
      2. Cyclic voltammetry (CV),
      3. Linear sweep voltammetry (LSV),
      4. Galvanostatic Intermittent Titration Technique (GITT), and/or
      5. Potentiostatic Intermittent Titration Technique (PITT),
   iii. A battery cycler, and/or
   iv. A device for applying advanced pulsed detection schemes.

'*In situ* module' is understood as is common in the art, such as an electrical module for enabling charging or discharging a battery with the battery component, such as enabling performing the measurements while the battery with the battery component is being charged or discharged.

'*Operando* module' is understood as is common in the art, such as an electrical module for enabling charging or discharging a battery with the battery component mimicking operational conditions (such as operational voltage, current, timescales, etc.), such as enabling performing the measurements while the battery with the battery component is being charged or discharged with electrical values identical or comparable with electrical values under normal use of the battery.

A 'temperature controller' is understood as is common in the art, such as an apparatus for controlling temperature, such as controlling temperature within the hollow element, such as comprising a temperature actuator, such as a heater and/or Peltier element and/or cooling fan and/or circulating bath and/or a cryostat, a regulator and optionally a temperature sensor, such as wherein the temperature sensor forms part of a closed controlling loop.

A 'magnet' is understood as is common in the art, such as a unit for applying an external magnetic field.

A scanning NV magnetometry instrument may comprise a permanent magnet, and optionally not comprise a tunable magnet, and use the permanent magnet for exerting a magnetic field, such as a small magnetic field, on the color center (NV) to split the mₛ = 1 and mₛ = -1 states.

A 'tunable magnet' is understood as a magnet, such as an electromagnet, enabling changing a scalar value and/or sign of the applied external magnetic field.

According to embodiments, the tunable magnet may be either or both of:
- Coil-based, such as where a normal current or a supercurrent is applied to coils to produce the magnetic field, and/or
- Based on a permanent magnet, such as where one or more permanent magnets are physically reconfigured to tune the external magnetic field on the sample, such as increasing the distance between the magnet and the sample and/or reorienting two or more permanent magnets with respect to each other, such as to enhance or cancel each other's magnetic field.

In a coil-based tunable magnet, the tunable magnet may comprise one or more uniaxial, biaxial or vector magnets. Soft magnetic materials may optionally further enhance the externally applied field. The NV radiofrequency antenna can be used to apply external magnetic fields locally (which may be useful for measuring paramagnetic susceptibility).

Superconducting and/or normal-conducting electromagnets, as well as permanent magnet designs (rotatable & distance-increasing), may be used for NV magnetometry.

Applying large external magnetic fields in NV magnetometry may advantageously be done along the NV quantization axis in order to improve the working of the sensor. The orientation of the NV axis can be controlled by terminating the diamond differently.

A 'vector magnet' is understood as is common in the art, such as an assembly of one or more magnets allowing a rotation of the magnetic field within a plane or in three dimensions.

A vector magnet be designed with one or more mechanically rotatable magnets.

A vector magnet may alternatively be designed and assembled with two or more electromagnets. An advantage may be that it may dispense with a need for mechanical rotation of the magnets.

The measurement instrument may be a nanoscale scanning sensor, such as a measurement instrument comprising:
- an atomic force microscope platform formed of monolithic diamond material, the atomic force microscope platform comprising one or more spin defects configured to emit fluorescent light, and an optical outcoupling structure formed by the monolithic diamond material and configured to optically guide the fluorescent light emitted by the one or more spin defects toward an output end of the optical outcoupling structure,
   wherein the one or more spin defects are located no more than 50 nm from a sensing surface of the atomic force microscope platform, and wherein the atomic force microscope platform including the optical outcoupling structure is formed of a diamond component having at least one linear dimension greater than 1 µm in length, and wherein the atomic force microscope platform further comprises an attachment region located remote from the outcoupling structure and configured to be attached to an atomic force microscope;
- an optical excitation source configured to generate excitation light directed to the one or more spin defects causing the one or more spin defects to fluoresce;
- an optical detector configured to detect the fluorescent light that is emitted from the one or more spin defect and that exits through the output end of the optical outcoupling structure after being optically guided therethrough; and
a mounting system comprising an atomic force microscope and configured to hold the atomic force microscope platform and control a distance between the sensing surface of the atomic force microscope platform and a surface of a sample while permitting relative motion between the sensing surface of the atomic force microscope platform and the sample surface, and/or wherein the measurement instrument is as described in US12169209B2, such as in claim 10 of US12169209B2, wherein US12169209B2 is hereby included by reference in entirety.

According to an embodiment there is presented a system, wherein the measurement technique is a Scanning Probe Microscopy technique, which is a magnetic imaging technique utilizing:
- a solid-state lattice sensor, such as a solid-state lattice sensor of diamond material or non-diamond material, such as hexagonal boron nitride or silicon carbide, wherein the solid-state lattice sensor is optionally configured as a scanning probe, the apex of said probe comprising one or more single spin defects, such as a nitrogen vacancy (NV), such as wherein the measurement instrument is a scanning NV magnetometry imaging apparatus,
the system is comprising, such as comprising all of:
- The hollow element, wherein the hollow element is being a glovebox or a sealed enclosure,
- The temperature controller, wherein the temperature controller is arranged to control temperature within the hollow element,
- The magnet, wherein the magnet is a vector magnet or a tunable magnet, wherein the magnet is arranged to apply an external magnetic field within the hollow element, and
- The electrical unit for applying electrical loads to the battery component during said measuring of said one or more magnetic properties of the battery component and/or for performing electrical analysis of battery component during the measuring of the one or more magnetic properties of the battery component.

### BRIEF DESCRIPTION OF DRAWINGS

The first and second aspect according to the invention will now be described in more detail with regard to the accompanying figures. The figures show one way of implementing the present invention and is not to be construed as being limiting to other possible embodiments falling within the scope of the attached claim set.
Figure 1 shows a flowchart according to an embodiment of the invention,
Figure 2 shows a schematic illustration of measurements according to embodiments of the invention,
Figure 3 shows a system according to an embodiment of the invention,
Figure 4 shows finite element simulations of a solid-state battery cell, simulated signal strengths and magnetometry detection limits,
Figure 5 shows the nanoscale magnetometry of battery materials, and
Figure 6 shows scanning NV magnetometry imaging on Li₂CoO₂ (LCO) powder particles.

### DETAILED DISCLOSURE OF THE INVENTION

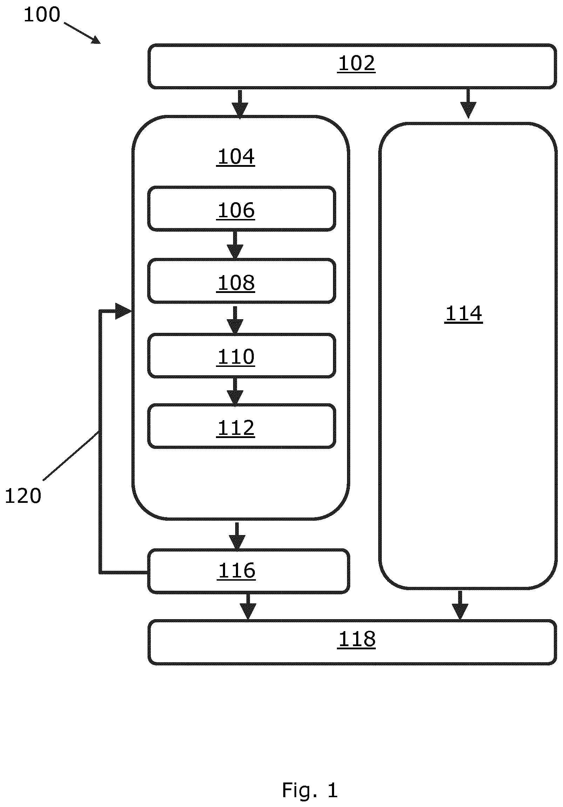

Figure 1 shows a flowchart according to an embodiment of the invention, comprising a method 100 for measuring one or more magnetic properties, such as a magnetic field, such as the magnetic field from a magnetization, and/or a magnetization and/or a magnetic state, of a battery component 332, and for enabling local detection of one or more magnetic inhomogeneities 342, such as one or more microscopic inhomogeneities, such as one or more nanoscopic inhomogeneities, in the battery component, said method comprising:
- Having the battery component being placed 102 in a hollow element shielding the battery component from atmospheric air and/or moisture, such as the hollow element being a glovebox,
- Subjecting 104 the battery component to a measurement of the one or more magnetic properties of the battery component with a measurement technique,
   wherein the measurement technique for carrying out the measurement is a scanning probe microscopy (SPM) technique,
   wherein the SPM measurement technique is utilizing a solid-state lattice sensor 336, such as a solid-state lattice sensor of diamond material or non-diamond material, such as hexagonal boron nitride or silicon carbide, wherein the solid-state lattice sensor is optionally configured as a scanning probe, the apex of said probe comprising one or more single spin defects, such as a nitrogen vacancy (NV),
   wherein the measurement technique for carrying out the measurement is having a submillimetre spatial resolution or a higher spatial resolution, such as double-digit micrometre spatial resolution or a higher spatial resolution, such as single-digit micrometre spatial resolution or a higher spatial resolution, such as submicrometre spatial resolution or a higher spatial resolution, such as double-digit nanometre spatial resolution or a higher spatial resolution, such as single-digit nanometre spatial resolution or a higher spatial resolution,
   wherein the measurement technique comprises:
      - a) movably positioning 106 a sensing surface of a solid-state lattice sensor, such as a solid-state lattice sensor of diamond material or non-diamond material, such as hexagonal boron nitride or silicon carbide, comprising one or more spin defects in the vicinity of the apex, such as in the apex, of the solid-state lattice sensor, at a first scanning position in proximity of the battery component,
      - b) irradiating 108 the one or more spin defects by applying optical radiation (L) and a microwave field continuously or in one or more pulses to the one or more spin defects such as to detect a Zeeman shift upon exposure of the irradiated one or more spin defects to the magnetic field of the battery component,
      - c) detecting 110 a photoluminescence (PL) output signal from the solid- state lattice sensor comprising the one or more spin defects,
      - d) scanning 112 the surface of the battery component in performing steps a) to c) at a series of scanning positions over at least a portion of the length of the battery component such as to obtain quantitative information on the magnetic field spatial distribution,
- Locally detecting 116 one or more magnetic inhomogeneities based on the measurement of the one or more magnetic properties of the battery component,
- Capturing evolution, such as electrochemical evolution, by repeating 120 one or more times:
   - Subjecting 104 the battery component to a measurement of the one or more magnetic properties of the battery component with a measurement technique, and
   - Locally detecting 116 one or more magnetic inhomogeneities based on the measurement of the one or more magnetic properties of the battery component,
- wherein the measurement is an *in situ,* such as an *operando,* measurement, such as repeated or continuous measurement while the battery component is being electrically operated 114, such as electrically operated in a manner being or mimicking a working situation, such as while charging and/or discharging, such as during a charge-discharge cycle.

Subsequent to the application of the method and/or as a final step, the method is ending 118.

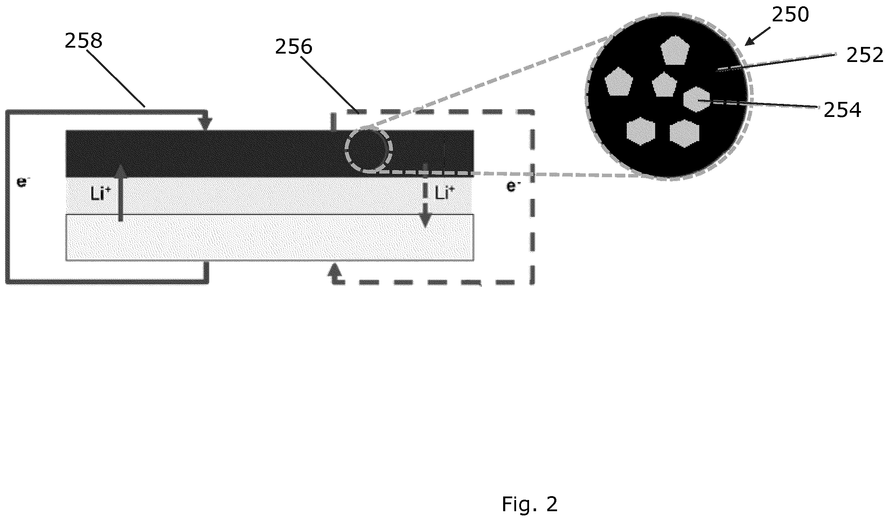

Figure 2 shows a schematic illustration of measurements according to embodiments of the invention, such as of nanoscale degradation processes 250 as shown in the zoom. Unlike traditional techniques that rely on macro-scale measurements, the present inventors have made the insight that with methods and systems according to the present invention, it is possible to detect sub-millimetre, such as micro-, such as nano-scale, magnetic fields that are invisible on a macro-scale, revealing new insights into battery degradation processes. The present invention may allow for real-time, sub-millimetre, such as micro-, such as nano-scale, observations of processes that were previously hidden, providing a much more detailed understanding of battery performance and degradation.

This may in turn be of relevance, e.g., for one or more of the purposes of enabling enhanced battery performance and longevity (e.g., by precisely identifying sources of degradation), increased safety (e.g., by early detection of issues like dendrite formation and interdiffusion, which in turn can enable early prevention of battery failures), and/or technological advancement (e.g., by providing a deeper understanding of battery degradation).

The figure illustrates that ions move between the electrodes solely by moving across an electrolyte, whereas electrons move in an external circuit to perform useful work. The figure furthermore shows nanoscale degradation processes 250, e.g., during operation wherein an electrical current is applied (such as during charging 256 or discharging 258, wherein current in the form of electrons flow through a wire connecting cathode and anode outside of the battery and the circuit is closed by ions, such as Li-ions flowing between the cathode and anode within the battery), which may lead to inhomogeneities, which may be magnetic inhomogeneities, which may in turn influence the magnetic footprint, such as one or more magnetic properties, including, e.g., magnetic order 252 and/or magnetic susceptibility 254, such as paramagnetic susceptibility.

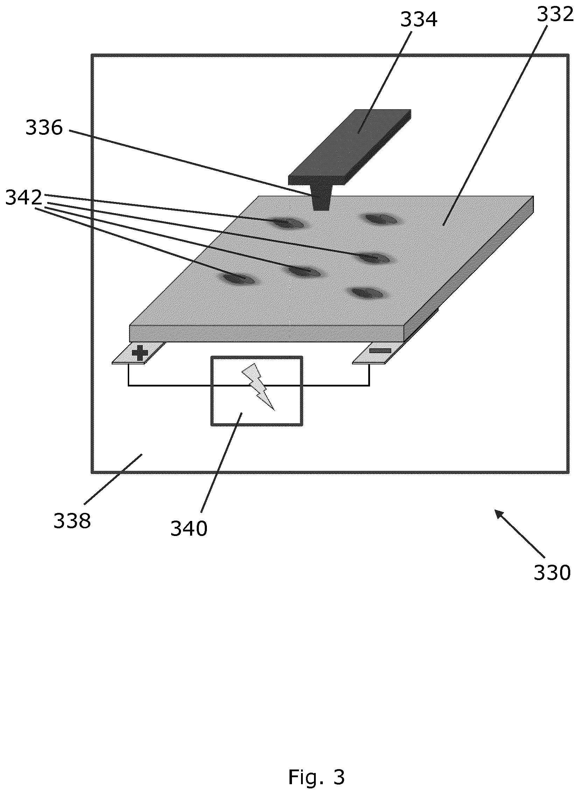

Figure 3 shows a system according to an embodiment of the invention, and more particularly shows a system 330 for measuring one or more magnetic properties, such as a magnetic field, such as the magnetic field from a magnetization, and/or a magnetization and/or a magnetic state, of a battery component 332, said system comprising:
- A measurement instrument 334 (wherein the part of measurement unit depicted in the figure is a scanning probe) for measuring one or more magnetic properties of a battery component with a measurement technique according to the first aspect of the invention, such as for carrying out the method according to the first aspect of the invention,
wherein the system is further comprising:
- A hollow element 338 for shielding the battery component from atmospheric air and/or moisture during the measuring of the one or more magnetic properties of the battery component, such as the hollow element being a glovebox, and/or
- An electrical unit 340 for applying electrical signals to the battery component during the measuring of the one or more magnetic properties of the battery component and/or for performing electrical analysis of battery component during the measuring of the one or more magnetic properties of the battery component, such as wherein the electrical unit is
   i. An *operando* module,
   ii. A Potentiostat with the capability of doing
      1. Galvanostatic cycling with potential limitations (GCPL),
      2. Cyclic voltammetry (CV),
      3. Linear sweep voltammetry (LSV),
      4. Galvanostatic Intermittent Titration Technique (GITT), and/or
      5. Potentiostatic Intermittent Titration Technique (PITT),
   iii. A battery cycler, and/or
   iv. A device for applying advanced pulsed detection schemes.

Figure 4 shows (a) finite element simulations of a 5 µm thin solid state battery cell (Li/LLZO/LCO), containing a dendritic defect grown through LLZO electrolyte from anode/electrolyte interface, and an inhomogeneous reaction front within the cathode. The simulations display the out-of-plane magnetic field (B_{z}) from the paramagnetic lithium as well as magnetic field strengths from a LiₓCoO₂ cathode subjected to an external magnetic field of 100 mT. (b) The simulated signal strengths and magnetometry detection limits (such as wherein the scanning NV magnetometry detection limits are indicated with the horizontal dashed lines, with each dashed line corresponding to an integration time, with the integration time for each dashed line indicated on the right hand side of the figure) as a function of the external magnetic field (Bₑₓₜ) for the paramagnetic lithium metal and LiₓCoO₂.

Figure 4(b) presents simulations on how magnetic imaging allows for full-cycle imaging of the flow and reactions of lithium ions and electrons in lithium-metal solid state batteries (SSBs) at room temperature. The schematics (in the lower level) 406 depict the solid-state battery cell with its the constituent materials: LiCoO₂ 408 (χ = 6.15 x 10⁻⁵), Li_{0.75}CoO₂ 410 (χ = 2.77 x 10⁻⁴), Li_{0.5}CoO₂ 412 (χ = 3.38 x 10⁻⁴), LLZO 414 (χ = 0), and metallic lithium 416 (χ = 1.37 x 10⁻⁵). The highlights are described in the following:
1) Cathode paramagnetism: We have conducted preliminary finite element calculations of the magnetic stray field from the cathode magnetization induced by applying 100 mT to common cathode materials LiₓCoO₂, LiFePO4, and LiNiₓMn_{y}Co_{1-x-y}O₂. In the (upper level) magnetic field map 402, we present data for LiₓCoO₂, where an inhomogeneous lithium composition *x* schematically represents the various state-of charge levels. An increase in x monotonously decreases the magnetic susceptibility according to bulk LiₓCoO₂ magnetometry. Applying a magnetic field of 100 mT induces lithium-dependent paramagnetic moments, which, in turn, generates a detectable magnetic stray field measured 50 nm above the surface that can be used to directly assess the local redox reactions, redox reactivity, and state-of-charge. As shown in Figure 4b, the stray fields at Bₑₓₜ = 100 mT from Li_{0.5}CoO₂ 418, Li_{0.75}CoO₂ 420, and LiCoO₂ 422 greatly exceeds the scanning NV magnetometry sensitivity 426 of ~50 nT with one second integration time using alternating current (AC) protocols, hence corroborating the feasibility of visualizing the cathode redox reactions.
2) Anode paramagnetism: Applying an external magnetic field of 100 mT produces a magnetic stray field from the paramagnetic lithium metal, which can be used to directly image the state-of-charge as well as spatially resolving dendrites.. In the (middle level) magnetic field map 404, magnetic effects from the cathode paramagnetism are omitted and the resulting paramagnetic field is measured 50 nm above the surface. It is particularly noted that this is forecasted to work not only for lithium metal anodes, but also a range of other anodes, such as the metallic anodes of Na, Mg, K, Al, and Ca. In Figure 4b, paramagnetic field strength of lithium metal 424 is plotted as a function of the external magnetic field (Bₑₓₜ).

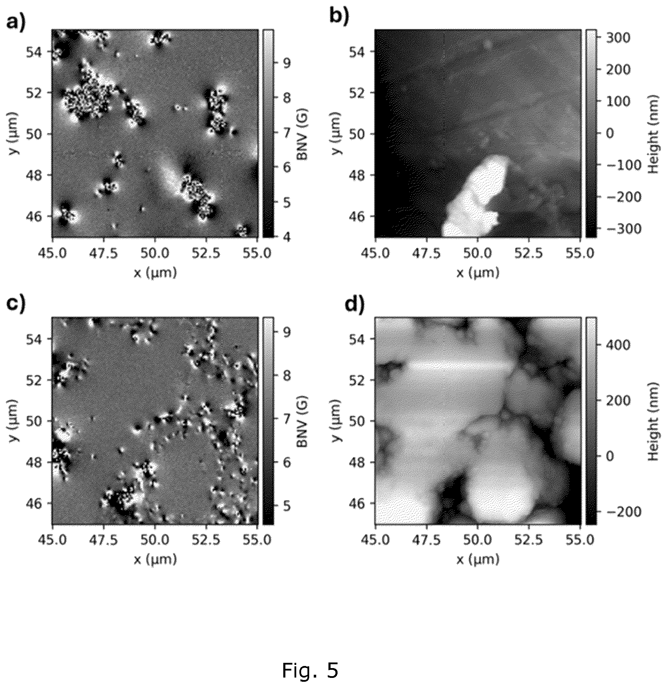

Figure 5 shows the first ever nanoscale magnetometry of battery materials including a) nanoscale magnetometry of Lithium cobalt oxide Li₂CoO₂ (LCO)-polytetrafluoroethylene (PTFE) composite, b) topography map of Lithium cobalt oxide Li₂CoO₂ (LCO)-polytetrafluoroethylene (PTFE) composite, c) nanoscale magnetometry Sintered LCO and d) topography map of Sintered LCO. The false-colour axis label, B_{NV}, in sub-figures a) and c) indicates the magnetic-field projection along the NV symmetry axis.

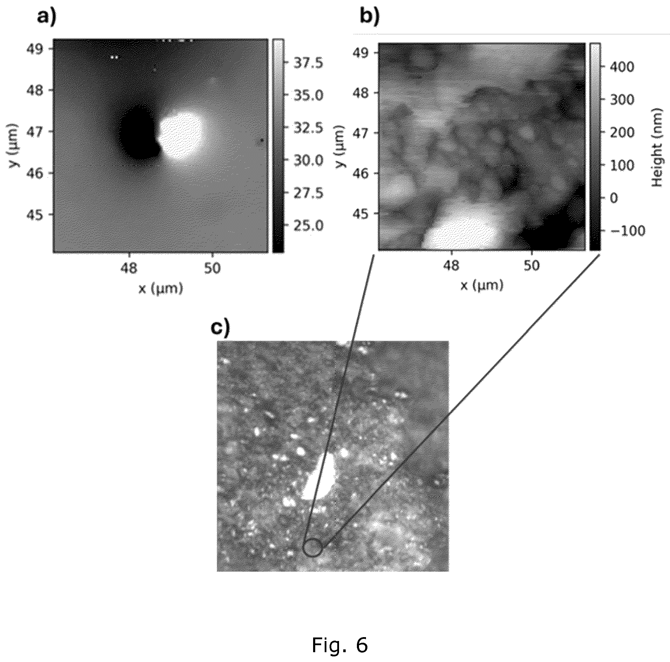

Figure 6 shows scanning NV magnetometry imaging on LCO powder particles deposited on an atomically flat nonmagnetic MgO surface, a) nanoscale magnetometry of a ferromagnetic centre on LCO, b) topography map of the scanned area, and c) optical microscope image from the scanned area. The nano sized ferromagnetic centre does not have any footprint in both topography scan and optical microscopy image and can only be detected by the NV sensor.

In Figures 5 and 6 three types of samples were prepared for Scanning NV (centre) magnetometry microscopy, as the first ever nanoscale magnetometry of battery materials
A) Lithium cobalt oxide Li₂CoO₂ (LCO)-polytetrafluoroethylene (PTFE) composite: LCO powder that was initially stored in the Glovebox (<0.1 ppm O₂, <0.1 ppm H₂O) moved out of the glovebox for sample preparation. The powder was then mixed and milled in air (without any solvent or dispersant but with PTFE as binder) for two hours at 160 rpm using a planetary ball mill. The LCO to PTFE weight ratio was 9:2. The powders were then pressed into pellets with a die diameter of 8 mm and 40 kN of load was applied. The samples were polished using battery grade polishing oil and washed by anhydrous ethanol for removing the debris. After polishing the samples were moved back to glovebox to dry for 48 hours and then packed into a moisture resistant pouch for transportation. In total these samples stayed under ambient air around 10 days.
B) Sintered LCO: Some samples from above were then sintered under air (ramp rate 1 degree C per minute for heating, 2° C per minute for cooling) at 900° C for 10 hours. Polishing was conducted as mentioned above. In total these samples stayed under ambient air around 10 days.
C) Powder particles on an atomically flat surface: Same LCO powders as above were sonicated inside anhydrous ethanol, and dispersed particles were deposited on an atomically flat Magnesium oxide (non-magnetic) via drop casting.

All these samples were investigated by scanning NV magnetometry equipment (Qnami AG, Muttenz, Switzerland). The energy levels of a nitrogen-vacancy (NV) spin were tracked to determine the magnetic field generated by each of the above samples. This was done by optically detected magnetic resonance (ODMR), where the NV centre fluorescence is recorded while an increasing microwave tone is applied. Once the microwave frequency *f* was in resonance with the spin energy s ("ms = ± 1"), the NV fluorescence reduced. The fluorescence reduction results from a higher change of relaxing the excited state via a non-radiative process through meta-stable singlet states. Two peaks with reduced fluorescence are observed to be split by the Zeeman effect, which enables the detection of magnetic fields.

Although the present invention has been described in connection with the specified embodiments, it should not be construed as being in any way limited to the presented examples. The scope of the present invention is set out by the accompanying claim set. In the context of the claims, the terms "comprising" or "comprises" do not exclude other possible elements or steps. Also, the mentioning of references such as "a" or "an" etc. should not be construed as excluding a plurality. The use of reference signs in the claims with respect to elements indicated in the figures shall also not be construed as limiting the scope of the invention. Furthermore, individual features mentioned in different claims, may possibly be advantageously combined, and the mentioning of these features in different claims does not exclude that a combination of features is not possible and advantageous.

## Claims

1. A method (100) for measuring one or more magnetic properties, such as a magnetic field and/or a magnetization and/or a magnetic state, of a battery component (332), and for enabling local detection of one or more magnetic inhomogeneities, such as one or more microscopic inhomogeneities, such as one or more nanoscopic inhomogeneities, in the battery component, said method comprising:
Subjecting (104) the battery component to a measurement of the one or more magnetic properties of the battery component with a measurement technique, wherein the measurement technique for carrying out the measurement is selected between,
• A scanning probe microscopy (SPM) technique,
• An electron-beam based technique, and/or
• An optical technique, where
i. the optical technique is non-invasive, and/or
ii. wherein a magnetic sensor, such as any magnetic sensor, is at the surface and/or outside the battery,
and wherein the measurement technique for carrying out the measurement is having a submillimetre spatial resolution or a higher spatial resolution, such as double-digit micrometre spatial resolution or a higher spatial resolution, such as single-digit micrometre spatial resolution or a higher spatial resolution, such as submicrometre spatial resolution or
a higher spatial resolution, such as double-digit nanometre spatial resolution or a higher spatial resolution, such as single-digit nanometre spatial resolution or a higher spatial resolution.

2. A method (100) according to claim 1, wherein the method is further comprising:
• Locally detecting (116) one or more magnetic inhomogeneities based on the measurement of the one or more magnetic properties of the battery component.

3. A method according to any of the preceding claims, wherein the one or more magnetic properties include at least a paramagnetic susceptibility.

4. A method according to any of the preceding claims, wherein the measuring of one or more magnetic properties comprises:
• Determining the one or more magnetic properties, such as at least an intensity and/or direction of a magnetic stray field at a first temperature, and
wherein the measurement further comprises, optionally repeatedly:
• Changing the temperature of the battery component to a new temperature, such as a temperature at which the previous one or more determinations of the one or more magnetic properties has not or have not taken place, and
• Determining the one or more magnetic properties, such as at least an intensity and/or direction of a magnetic stray field at the new temperature.

5. A method according to any of the preceding claims, wherein the method comprises probing buried structures, such as structures below a layer, such as a surface layer, being different to the buried structures.

6. A method according to any of the preceding claims, wherein the measurement technique is selected between
i. The Scanning Probe Microscopy technique, and/or
ii. The electron-beam based technique.

7. A method (100) according to any of the preceding claims, wherein the measurement technique is a Scanning Probe Microscopy technique, which is a magnetic imaging technique utilizing any of:
• a solid-state lattice sensor (336), such as a solid-state lattice sensor of diamond material or non-diamond material, such as hexagonal boron nitride or silicon carbide, wherein the solid-state lattice sensor is optionally configured as a scanning probe, the apex of said probe comprising one or more single spin defects, such as a nitrogen vacancy (NV),
• a Superconducting Quantum Interference Device (SQUID) sensor, such as a scanning SQUID sensor,
• a Hall sensor, such as configured as a scanning Hall probe,
• A magneto-resistive sensor, such as configured as a scanning magneto-resistive probe, such as a magneto-resistive sensor with an operating current in which the resistance of said sensor corresponds to the local magnetic field,
• a Magnetic Force Microscope (MFM),
• a Scanning Tunnelling Microscope (STM), wherein the detection of a spin-component of tunnelling current is used to infer the local magnetization of the sample, or
• an Atomic Force Microscope (AFM), such as a non-contact Atomic Force Microscope (nc-AFM) or Magnetic Exchange Force Microscopy (MExFM), wherein the local forces related to magnetic exchange between the sample and an atomic force microscopy tip is used to generate a map of the magnetic state of the sample.

8. A method (100) according to claim any of the preceding claims, wherein the measurement technique comprises:
• a) movably positioning (106) a sensing surface of a solid-state lattice sensor, such as a solid-state lattice sensor of diamond material or non-diamond material, such as hexagonal boron nitride or silicon carbide, comprising one or more spin defects in the vicinity of the apex, such as at or in the apex, of the solid-state lattice sensor, at a first scanning position in proximity of the battery component,
• b) irradiating (108) the one or more spin defects by applying optical radiation (L) and a microwave field continuously or in one or more pulses to the one or more spin defects such as to detect a Zeeman shift upon exposure of the irradiated one or more spin defects to the magnetic field of the battery component,
• c) detecting (110) a photoluminescence (PL) output signal from the solid- state lattice sensor comprising the one or more spin defects,
• d) scanning (112) the surface of the battery component in performing steps a) to c) at a series of scanning positions over at least a portion of the length of the battery component such as to obtain quantitative information on the magnetic field spatial distribution.

9. A method (100) according to any of the preceding claims, wherein
the measurement technique, such as the scanning probe microscopy technique, is
• having a submicrometre spatial resolution or a higher spatial resolution, such as double-digit nanometre spatial resolution or a higher spatial resolution, such as single-digit nanometre spatial resolution or a higher spatial resolution.

10. A method (100) according to any of the preceding claims, wherein the method comprises capturing evolution, such as electrochemical evolution, by repeating one or more times:
• Subjecting the battery component to a measurement of the one or more magnetic properties of the battery component with the measurement technique, and
• Locally detecting one or more magnetic inhomogeneities based on the measurement of the one or more magnetic properties of the battery component,
such as wherein electrochemical reactions are induced, such as by having the battery component being electrically operated (114) between and/or during the measurements, such as by having the battery component being electrically operated, such as in a manner being or mimicking a working situation, such as charging and/or discharging, such as performing a charge-discharge cycle, between and/or during the measurements.

11. A method (100) according to any of the preceding claims, wherein the measurement is an *in situ,* such as an *operando,* measurement, such as repeated or continuous measurement while the battery component is being electrically operated (114), such as electrically operated in a manner being or mimicking a working situation, such as while charging and/or discharging, such as during a charge-discharge cycle.

12. A method (100) according to any of the preceding claims, wherein the method comprises providing a battery component with one or more magnetic inhomogeneities, such as wherein the one or more magnetic inhomogeneities are resulting from any one or more of:
• rock salt formation in cathode materials,
• oxygen loss in cathode materials,
• phase transition in cathode and anode materials,
• magnetically ordered particles and phases in battery cathode materials,
• transition metal dissolution,
• interdiffusion between transition metal ions and active ions, such as lithium ions,
• different states of charge in cathode and anode materials,
• induced magnetization in cathode and/or anode materials,
• dendrite formation during battery operation,
• interdiffusion at cathode/electrolyte as well as anode/electrolyte interface,
• cathode and anode materials decomposition,
• solid electrolyte interphase (SEI) formation, and/or
• cathode electrolyte interphase (CEI) formation.

13. A method (100) according to any of the preceding claims, wherein each of the magnetic inhomogeneities has a largest dimension being 100 nm or less, such as 10 nm or less.

14. A system (330) for measuring one or more magnetic properties, such as a magnetic field and/or a magnetization and/or a magnetic state, of a battery component (332), said system comprising:
• A measurement instrument (334) for measuring one or more magnetic properties of a battery component with a measurement technique according to any of the preceding claims, such as for carrying out the method according to any of the preceding claims,
wherein the system is further comprising one or more or all of:
• A hollow element (338) for shielding the battery component from atmospheric air and/or moisture during the measuring of the one or more magnetic properties of the battery component, such as the hollow element being a glovebox or a sealed enclosure,
• A temperature controller, such as comprising
i. a temperature actuator, such as a heater and/or Peltier element and/or cooling fan and/or circulating bath,
ii. a regulator and
iii. optionally a temperature sensor,
• A magnet, such as a vector magnet and/or a tunable magnet, and/or
• An electrical unit (340) for applying electrical loads to the battery component during said measuring of said one or more magnetic properties of the battery component and/or for performing electrical analysis of battery component during the measuring of the one or more magnetic properties of the battery component, such as wherein the electrical unit is
i. An *in situ* module, such as an *operando* module,
ii. A Potentiostat with the capability of doing
1. Galvanostatic cycling with potential limitations (GCPL),
2. Cyclic voltammetry (CV),
3. Linear sweep voltammetry (LSV),
4. Galvanostatic Intermittent Titration Technique (GITT), and/or
5. Potentiostatic Intermittent Titration Technique (PITT),
iii. A battery cycler, and/or
iv. A device for applying advanced pulsed load schemes.

15. A system according to claim 14, wherein the measurement technique is a Scanning Probe Microscopy technique, which is a magnetic imaging technique utilizing:
• a solid-state lattice sensor (336), such as a solid-state lattice sensor of diamond material or non-diamond material, such as hexagonal boron nitride or silicon carbide, wherein the solid-state lattice sensor is optionally configured as a scanning probe, the apex of said probe comprising one or more single spin defects, such as a nitrogen vacancy (NV), such as wherein the measurement instrument is a scanning NV magnetometry imaging apparatus,
the system is comprising:
• The hollow element (338), wherein the hollow element is being a glovebox or a sealed enclosure,
• The temperature controller, wherein the temperature controller is arranged to control temperature within the hollow element,
• The magnet, wherein the magnet is a vector magnet or a tunable magnet, wherein the magnet is arranged to apply an external magnetic field within the hollow element, and
• The electrical unit (340) for applying electrical loads to the battery component during said measuring of said one or more magnetic properties of the battery component and/or for performing electrical analysis of battery component during the measuring of the one or more magnetic properties of the battery component.
